# EUROPEAN PATENT APPLICATION

(11) **EP 2 123 792 A1**
(43) Date of publication of application: **25.11.2009**
(21) Application number: 07850272.1
(22) Date of filing: 07.12.2007
(51) Int. Cl.: C23C 16/27, C01B 31/02, C23C 16/503, C23C 16/448

(54) **PROCESS AND APPARATUS FOR PRODUCING CARBONACEOUS FILM**

(30) Priority: 07.12.2006 JP 2006330917
(71) Applicant: National University Corporation Nagoya University, Nagoya-shi, Aichi 464-8603 (JP); The University of Tokyo, Bunkyo-ku, Tokyo 1138654 (JP)
(72) Inventor: KOUSAKA, Hiroyuki, Nagoya-shi Aichi 464-8603 (JP); KOIZUMI, Hiroyuki, Kanagawa 229-8510 (JP); HAMAJIMA, Eri, Nagoya-shi, Aichi 464-8603 (JP); UMEHARA, Noritsugu, Nagoya-shi, Aichi 464-8603 (JP); ARAKAWA, Yoshihiro, Bunkyo-hu, Tokyo 113-8656 (JP)
(74) Representative: Bannerman, David Gardner
(86) International application number: PCT/JP2007/073685
(87) International publication number: WO 2008/069312

(57) **Abstract**

This invention provides a process and apparatus for producing a carbonaceous film such as a DLC film using a solid raw material without the need to supply a high energy radiation such as a laser beam. The process comprises providing a solid organic material as a raw material, applying a discharge energy to the material to form plasma, and depositing the plasma onto a base discharge means (10). The discharge means (10) comprises a pair of electrodes (a raw material holder) (12, 14) for holding a raw material (50) and voltage applying means (20) for applying voltage across the electrodes.

## Description

### TECHNICAL FIELD

The present invention relates to a process and apparatus for producing a carbonaceous film, and more particularly relates to a process for producing a carbonaceous film, by forming a plasma from a solid raw material through discharge energy and an apparatus using this process.

### BACKGROUND ART

Diamond-like carbon (hereafter notated as "DLC") is a generic term for amorphous carbonaceous materials whose basic structure is a carbon network having SP³ bonds identical to those of diamond and SP² bonds identical to those of graphite. DLC has attracted attention as a high-performance material capable of exhibiting superior characteristics, including mechanical characteristics such as high hardness, wear resistance, low friction coefficient and surface smoothness, chemical characteristics such as resistance to chemicals and corrosion resistance, as well as electric characteristics such as insulation. As is known, adding heteroelements (for instance fluorine (F)) to DLC (which typically consists essentially of carbon (C) and hydrogen (H)) has the effect of imparting capabilities previously absent in DLC, or of enhancing existing capabilities of DLC.

Conventional processes for forming film-like DLC on the surface of a substrate (i.e. processes for producing a DLC film) include, for instance, plasma CVD, wherein a raw material gas fed into a reactor (chamber) is excited into plasma and is deposited onto the substrate surface. JP 2004-169183 A and JP 8-217596 A are prior art documents relating to this technology. Further, JP 8-100266 A discloses a technology of producing a thin film such as a DLC film by plasma CVD, wherein a liquid carbon compound is fed into a reaction tube by ultrasonic spraying. Other disclosed processes for forming a DLC film include laser ablation processes in which a laser beam is irradiated onto a raw material (target) to vaporize the raw material, such that the vaporized raw material is deposited then onto a substrate surface. For instance, JP 9-118976 A is a prior art document relating to this technology.

In ordinary conventional processes for producing a DLC film by plasma CVD, plasma has been generated from a gaseous raw material (raw material gas), as described above. To produce ordinary DLC, for instance a hydrocarbon gas such as methane (CH₄), acetylene (C₂H₂), benzene (C₆H₆) or the like have been used as the raw material gas. To produce a DLC comprising fluorine in the composition (hereinafter "fluorine-containing DLC"), there have been used mixed gases of a fluorocarbon gas such as CF₄ or C₆F₆ and a hydrocarbon gas. However, handling such gaseous raw materials is usually troublesome. As a result, conventional equipment for producing DLC films by plasma CVD were of necessity complex, bulky and costly. The technology disclosed in JP 8-100266 A uses a carbon compound that is liquid at normal temperature. However, such liquid carbon compounds (for instance compounds ordinarily known as organic solvents, such as n-hexane, benzene, pyridine or the like, benzene in working examples) have comparatively low molecular weights, and hence their handling is still troublesome. Herein, equipment must be constructed taking into account, among others, the volatile and flammable character of these compounds (organic solvents or the like). This results in bulkier and more complex equipment, among other disadvantages.

Meanwhile, JP 9-118976 A discloses a technology of producing a DLC film by laser ablation, using a polymeric material in a target. However, laser ablation requires ordinarily high-power sources, of several hundreds to several thousands of W or more, which is disadvantageous in terms of, for instance, energy costs. The requirement for such high-power sources entails more complex and bulkier equipment, and also higher equipment costs, on account of expensive laser generators (laser oscillators or the like).

### DISCLOSURE OF THE INVENTION

Therefore, it is an object of the present invention to provide a process for producing a carbonaceous film, such as a DLC film or the like, using a solid raw material and requiring no supply of high-energy radiation such as laser radiation. A further object of the present invention is to provide an apparatus that allows producing a carbonaceous film, such as a DLC film or the like, using a solid raw material and requiring no supply of high-energy radiation such as laser radiation.

The inventors perfected the present invention upon finding that forming a plasma from a solid raw material, utilizing discharge energy, allows producing a DLC film and other carbonaceous films, with good efficiency, from the solid raw material.

One invention disclosed herein relates to a film production process of forming a carbonaceous film on a substrate. The process comprises preparing a solid organic material as the raw material (typically, an organic polymer material having, as a main component, a polymer the main chain of which is based on carbon-carbon bonds). The process comprises also forming a plasma from the material by applying discharge energy to the material; and forming a carbonaceous film by depositing the plasma (i.e. plasma constituent component) onto a substrate.
This production process uses, as a raw material, a solid organic material having good handleability (hereinafter, the solid organic material used in the present invention is also referred to as "solid resin material"), such that a plasma is formed from the solid resin material by means of discharge energy. Typically, the surface of a solid resin material is heated by a discharge current, to gasify (for instance sublimate) the surface portion of the material, such that at least part of the gasified product is ionized to form a plasma from the solid resin raw material. Instead of a gaseous raw material, the process uses, as a raw material, a solid resin material having good handleability, and relies on an apparatus configuration that is amenable to simplification and size reduction (requiring, for instance, no high-power input device such as a laser generator or the like). As a result, plasma can be formed efficiently from the solid resin material. An intended carbonaceous film can be produced efficiently on a substrate by causing the plasma to be deposited on the substrate (vapor deposition). The production process allows forming a carbonaceous film (DLC film or the like) on the substrate by way of a production process that requires no gas, for instance, no raw material gas, carrier gas or the like (i.e. a gas-less production process). Such a gas-less film formation process allows simplifying considerably gas infusion and exhaust systems, as compared with film formation processes that employ raw material gases or the like, and allows hence realizing a highly compact film formation apparatus.

Preferably, energy is applied in a non-steady manner (typically in pulses). Plasma can be generated thereby efficiently from a solid resin material, with energy costs kept low. In a below-described scheme in which plasma is accelerated by a self-induced magnetic field, the plasma can be electromagnetically accelerated, with good efficiency, as a result of such non-steady discharge (for instance, by repeating an operation involving instantaneous flow of a large current).
Formation of a plasma from a solid resin material through application of discharge energy, as described above, may include creating a discharge along the surface of the solid resin material (surface discharge, for instance pulsed surface discharge), gasifying (for instance, subliming) the surface portion of the solid resin material by way of the discharge current, and forming a plasma by ionizing at least part of the gasified product. Plasma formation may also include generating a discharge (for instance, arc discharge, preferably pulsed arc discharge) by causing a current to flow through a gasified product of the solid resin material and/or through a plasma formed through ionization of the gasified product (typically, a gasified product generated through surface discharge and/or a plasma formed through ionization of the gasified product), gasifying the solid resin material by way of the discharge current, and forming a plasma by ionizing at least part of the gasified product (in other words, forming a gas that contains a plasma resulting from exciting into plasma at least part of the gasified product generated from the solid resin material). For instance, gasification and plasma formation of the solid resin material can be sustained by initially applying discharge energy to the solid resin material by way of the above-mentioned surface discharge, followed by application of discharge energy through discharge in the form of current flowing through the gasified product and/or the plasma (discharge that may be prompted by the above surface discharge).

In a preferred embodiment of the process for producing a film disclosed herein, the process further comprises a step of accelerating the formed plasma towards the substrate by way of electromagnetic forces (i.e. electromagnetic acceleration). Such an embodiment allows the generated plasma (plasma constituent component) to be deposited more appropriately onto the substrate (the surface of the substrate disposed facing the acceleration direction of the plasma). A film of higher quality can be obtained thereby (for instance, a film where at least one from among compactness, substrate adherence and surface smoothness is improved). The rate at which the film is formed (film formation rate) can also be increased. The above-mentioned electromagnetic acceleration is particularly effective when the process is used, for instance, for producing a diamond-like carbon (DLC) film. Preferably, the substrate is disposed within an area irradiated by the accelerated plasma.
Herein, "acceleration towards the substrate" refers to increasing the motion speed of the plasma in a direction (acceleration direction) along which there increases the relative speed of the plasma with respect to the substrate surface. Preferably, acceleration takes place in a direction such that the angle formed between the acceleration direction of the plasma and the substrate surface is of about 30° or more (more preferably, about 60° or more). In particular, plasma is accelerated in a direction such that the angle is substantially 90°. In other words, the substrate is preferably disposed within about 60° relative to the acceleration direction of the plasma (typically, within a cone of vertex no greater than 60° whose perpendicular line is the acceleration direction of the plasma (acceleration vector) and whose apex is the surface center of the discharge surface of the solid resin material). Preferably, the angle is about 30° or less (for instance, substantially 0°).
Acceleration of the plasma by the electromagnetic forces can be realized, for instance, through the interaction of the current (J) flowing on account of the discharge and the magnetic field B induced by that current (self-induced magnetic field), which give rise to an electromagnetic force (J × B) that acts on the charge particles in the plasma. The plasma can also be electromagnetically accelerated by means of an external magnetic field generated by, for instance, a permanent magnet and/or an electromagnetic coil, instead of, or in addition to, the self-induced magnetic field.

The process disclosed herein can be used for producing a carbonaceous film (film having carbon as a main component) of various forms (structures), such as an amorphous form, a graphite form or the like. The process can be preferably used as a process for producing a hard carbonaceous film on a substrate. In particular, the process may be preferably used for (production of) DLC films. For instance, the process is appropriate for producing DLC films having a hardness of about 5 GPa or more (typically, about 5 to 100 GPa), more preferably of about 10 GPa (typically, about 10 to 50 GPa, for instance 10 to 30 GPa).
Conceptually, the term "DLC (diamond-like carbon)" as used in the present description denotes an amorphous carbonaceous material the basic structure (basic backbone) whereof is a carbon network comprising SP³ bonds and SP² bonds. The ratio of SP³ bonds to SP² bonds is not particularly limited. A typical example of DLC as referred to herein may be DLC in which the proportion of SP³ bonds ranges, for instance, from about 10 to 90%. Conceptually, the term DLC encompasses herein, for instance, DLC consisting essentially of carbon (C), DLC consisting essentially of carbon and hydrogen (H), and DLC comprising elements other than hydrogen (heteroelements) in addition to carbon. In DLC comprising the above-mentioned heteroelements, the heteroelements may be present in any form. The DLC may have, for instance, a structure in which part of the C that makes up the network is replaced by a heteroelement, or a structure in which part or the entirety of H bonded to the C in the network is replaced by a heteroelement. The heteroelement may be one, two or more selected from elements such as fluorine (F), nitrogen (N), boron (B) or the like.

The presence of the above-mentioned basic structure in the obtained carbonaceous film can be ascertained, for example, by observing the Raman spectrum of the film. For instance, ordinary nanoindentation can be preferably used as the process for measuring the hardness of the film. The presence of the heteroelements in the obtained film can be ascertained, for instance, through Auger electron spectroscopy of the film. The heteroelements may derive, for instance, from the raw material used, the plasma atmosphere, the electrode materials or the like.

The technology disclosed herein uses a solid organic material (meaning an organic material that is solid at least at room temperature (for instance 25°C)) as the raw material. Preferably, there is used a solid organic polymer material having, as a main component, a polymer the main chain of which is based on carbon-carbon bonds. The organic polymer (typically, a substantially insulating organic polymer) that makes up the organic polymer material is preferably a polymer (high-molecular weight compound) that gasifies readily when heated through discharge or the like (the concept gasification includes herein, for instance, vaporization, sublimation, decomposition (for instance thermal decomposition or depolymerization)). Preferably, the organic polymer sublimates readily when heated. Preferably, the organic polymer is little prone to surface charring (carbonization residues on the surface) when heated. Such a polymer material having an organic polymer as a main component is suitable for undergoing smooth and gradual gasification (preferably, sublimation) at the outermost surface by way of discharge energy.

Preferred solid organic materials (raw material for producing a carbonaceous film) in the present invention are materials having a fluorine-containing solid resin as a main component (typically, a so-called fluororesin). More specifically, there can preferably be used an organic polymer material (which may be a polymer material consisting essentially of a fluororesin) having, as a main component, a fluororesin, for instance, polytetrafluoroethylene (PTFE), a tetrafluoroethylene-perfluoroalkyl vinyl ether copolymer (PFA), a tetrafluoroethylene-hexafluoropropylene copolymer (FEP), an ethylene-tetrafluoroethylene copolymer (ETFE), polyvinylidene fluoride (PVdF), polychlorotrifluoroethylene (PCTFE), an ethylene-chlorotrifluoroethylene copolymer (ECTFE) or the like. In particular, the polymer material has preferably PTFE as a main component.

Suitable examples of DLC films produced in accordance with the process disclosed herein include, for instance, DLC films comprising fluorine. Preferably, such fluorine-containing DLC films can be produced in accordance with, for instance, any of the film production processes disclosed herein, and using, in the raw material, a polymer material the main component whereof is a solid resin (for instance, PTFE) comprising fluorine. The content of fluorine in the obtained DLC film can be adjusted through, for instance, the type of raw material used (for example, the content of fluorine in the raw material) and the production conditions (for instance, discharge conditions, and whether or not the above-mentioned electromagnetic acceleration is used, and in what form if so).
Depending on the above production conditions and the like, it is also possible to produce a carbonaceous film (for instance a DLC film) containing essentially no fluorine when using, as a raw material, a polymer material whose main component is a solid resin comprising fluorine.

Another invention disclosed herein relates to a film production apparatus for forming a carbonaceous film on a substrate. The apparatus comprises a raw material holder that holds a solid organic material (solid resin material) as a raw material. The apparatus comprises also discharge means configured such that a plasma can be formed from the material by imparting discharge energy to the material. The discharge means comprises typically pair of electrodes and a voltage applying means for applying voltage across the electrodes.
An apparatus having such a configuration can be used for generating plasma efficiently from a solid resin material having good handleability. The intended carbonaceous film (for instance a DLC film) can be formed efficiently on the substrate by causing the plasma (plasma constituent component) to be deposited on the substrate. The apparatus requires no piping for infusing a raw material gas or a high-power device such as a laser generator. Hence, the apparatus can have a remarkably simple and compact construction, as compared with, for instance, conventional plasma CVD equipment (using a raw material gas) and laser ablation equipment. One or both electrodes in the above-mentioned pair of electrodes may be used as the raw material holder or as a constituent member thereof.
The raw material holder may hold the solid resin material between the pair of electrodes. In a preferred embodiment, the raw material holder is configured in such a manner that the solid resin material is held while in direct contact with the electrodes. The way in which the apparatus disclosed herein is embodied may include instances in which the solid resin material is held while not in direct contact with the electrodes, so long as the discharge energy can be applied.
In a preferred embodiment of the apparatus disclosed herein, the discharge means is configured in such a manner that discharge takes place at least along the surface of the solid resin material (surface discharge, preferably pulsed surface discharge). The discharge means may also be configured so as to be capable of, subsequent to surface discharge, eliciting a discharge (for instance, arc discharge, preferably pulsed arc discharge) in which a current flows through the plasma generated on account of the surface discharge.
The shape and arrangement of the electrodes are not particularly limited, so long as the discharge means can be constructed in the above-described manner. For instance, two plate-like electrodes may be disposed parallelly or non-parallelly. The shape and size (surface area or the like) of the electrodes may be identical or different. The pair of electrodes may be arranged coaxially. The shape and/or arrangement of the electrodes may be symmetrical or asymmetrical.

The apparatus can comprise a plasma position control means for controlling the position (motion direction, motion speed, expansion and the like) of the formed plasma. A desired carbonaceous film can be produced yet more efficiently when using an apparatus comprising such means. The electromagnetic forces may be achieved by way of the above-described self-induced magnetic field, by way of an external magnetic field (for instance, an external magnetic field generated by a permanent magnet, an electromagnetic coil or the like), or using a combination of the foregoing.
The plasma position control means may function, for instance, as an electromagnetic acceleration means for accelerating the formed plasma in a direction of separation from the organic material (typically, a direction towards the substrate), by way of electromagnetic forces. The plasma can be better guided thereby towards the substrate. This allows producing efficiently a carbonaceous film (for instance, a DLC film) of yet higher quality. The electromagnetic acceleration means is preferably configured so that plasma can accelerate in a direction such that the angle formed between the acceleration direction of the plasma and the substrate surface is of about 30° or more (more preferably, about 30° or more, yet more preferably, about 60° or more, and in particular, of substantially 90°).

In a preferred embodiment of the film production apparatus disclosed herein, at least part of the pair of electrodes is provided in a shape such that the electrodes face each other protruding out of the organic material (preferably, protruding beyond the material towards where the substrate is disposed). For instance, the material (solid resin material) may be disposed between parallel plate-like electrodes, and the electrodes may extend substantially parallelly, in the longitudinal direction thereof (preferably towards the substrate), protruding beyond the solid resin material. The solid resin material may also be disposed between an outer electrode and an inner electrode among coaxial electrodes that extend in the longitudinal direction thereof (preferably towards the substrate), protruding beyond the solid resin material. In such a configuration, the position (motion direction, expansion and the like) of the plasma can be suitably controlled using the protruding portion of the electrodes. A desired carbonaceous film can be produced more efficiently thereby.
Preferably, the electromagnetic acceleration means is formed so as to be capable of accelerating the plasma in the above-mentioned direction, between the protruding electrodes, by way of a self-induced magnetic field that is generated resulting from the discharge. Such a configuration allows producing yet more efficiently a carbonaceous film (for instance a DLC film) of higher quality.

In the film production apparatus disclosed herein, the voltage applying means may comprise a capacitor electrically connected between the pair of electrodes; and may be configured in such a manner that a plasma is formed from the material through discharge of charge stored in the capacitor. Such a configuration allows realizing the above-described discharge (in particular, discharge of a large current flowing for a short time, suitable for electromagnetic acceleration of plasma by way of the self-induced magnetic field) relying on an apparatus configuration that is amenable to simplification and size reduction. The discharge may be surface discharge, or some form of discharge other than surface discharge (for instance, arc discharge), or a combination of these two (for instance, surface discharge followed by arc discharge).

The film production apparatus disclosed herein can further comprise a discharge timing control means for controlling timing of the discharge along the surface of the material (i.e. surface discharge that shorts the pair of electrodes). The discharge timing control means may comprise an igniter that induces the discharge (for instance, discharge of charge stored in the capacitor). The igniter may induce the discharge (for instance surface discharge) by temporarily increasing conductivity between the pair of electrodes. In a preferred embodiment, the discharge timing control means is configured in such a manner that the igniter causes a small discharge (trigger discharge) between the electrodes, whereupon the small discharge induces discharge (main discharge) of the charge stored in the capacitor.

The process for producing a carbonaceous film according to the present invention allows efficiently producing an intended carbonaceous film on a substrate, using as a raw material a solid resin material having good handleability. Likewise, the apparatus for processing a carbonaceous film according to the present invention allows efficiently producing an intended carbonaceous film on a substrate while relying on a remarkably simple and compact construction as compared with conventional equipment (in which raw material gases are used).

### BRIEF DESCRIPTION OF THE DRAWINGS

Fig. 1 is an explanatory diagram illustrating schematically the configuration and operation of a film production apparatus according to Example 1;
Fig. 2 is a perspective-view diagram illustrating schematically the configuration of the film production apparatus according to Example 1;
Fig. 3 is a diagram of Fig. 2 along the direction of arrow III;
Fig. 4 is an explanatory diagram illustrating schematically the configuration of a film production apparatus according to Example 2;
Fig. 5 is an explanatory diagram illustrating schematically the configuration of a film production apparatus according to Example 3;
Fig. 6 is an explanatory diagram illustrating schematically the configuration of a film production apparatus according to Example 4;
Fig. 7 is an explanatory diagram illustrating schematically the configuration a film production apparatus according to Example 5;
Fig. 8 is a graph illustrating Raman spectra of a film obtained in Example 6 under conditions of 1 J/shot;
Fig. 9 is a graph illustrating Raman spectra of a film obtained in Example 6 under conditions of 3 J/shot;
Fig. 10 is a graph illustrating a thickness distribution in the left-right direction of a film obtained in Example 8;
Fig. 11 is an explanatory diagram illustrating schematically another configuration example of a film production apparatus according to the present invention; and
Fig. 12 is an explanatory diagram illustrating schematically another configuration example of a film production apparatus according to the present invention.

### BEST MODE FOR CARRYING OUT THE INVENTION

Preferred embodiments of the present invention are explained below. Any features other than the features specifically set forth in the present description and which may be necessary for carrying out the present invention can be regarded as design matter for a person skilled in the art based on known techniques in the technical field in question. The present invention can be carried out on the basis of the disclosure of the present description and common technical knowledge in the technical field in question.

The technology disclosed herein uses, as a raw material (which can also be referred to as a film forming material, plasma source, carbon source or the like), an organic material exhibiting overall a solid state and having, as a main component, an organic compound comprising carbon atoms (C) (typically, an organic compound comprising carbon (C) and other elements, for instance hydrogen (H)). Preferably, the organic compound is an organic compound having a molecular weight (which may be the average molecular weight when appropriate) of at least 100, and exhibits a solid state at room temperature. Preferred typical examples of such a raw material (solid resin material) include polymer materials having, as a main component, a polymer the main chain of which is based on carbon-carbon bonds (preferably, a linear polymer). For instance, a solid resin material having a subliming organic compound (typically an organic polymer) as a main component can be preferably used as the raw material in the process disclosed here. Various solid organic compounds (typically, organic polymers) having known properties as solid propellants in the field of pulsed plasma thrusters (PPTs), which are a kind of electric thrusters used for attitude control and the like in space satellites, can be preferably used as the main component of the raw material employed in the film production process disclosed here.
Although not particularly limited thereto, specific examples of the organic polymer that can be used as the main component of the raw material include, for instance, fluorocarbon resins such as tetrafluoroethylene; aromatic vinyl resins such as polystyrene or poly(α-methyl styrene); olefin resins such as polyethylene or polypropylene; as well as polyacetylene, polyacetals, polyimides, polyvinyl chloride, polycarbonate (PC), polyphenylene sulfide (PPS), polyether ether ketone (PEEK) and the like. Further examples of the organic compound that can be used as the main component of the raw material include, for instance, adamantane as well as derivatives or analogs thereof (for instance, diadamantane).
The solid organic compound (solid resin material) may also be a composition comprising two or more solid organic compounds (for instance, two or more organic polymers of dissimilar composition). The raw material may also contain materials other than the solid organic compound (organic compounds that are liquid at room temperature, metallic microparticles or the like). Such a raw material can be prepared in various ways that include, for instance, procurement (purchase or the like) of a commercially available material, appropriate processing (mixture, molding or the like) of a commercially available material, or synthesis (polymerization or the like) in accordance with known methods.

A plasma is formed from such a solid resin material through application of discharge energy to the material. For instance, the material is gasified through discharge along the surface of the material (surface discharge). A plasma is formed then through ionization of at least part of the gasified product. In a preferred embodiment, gasification of the solid resin material and plasma formation are initiated by surface discharge. Subsequently, gasification of the solid resin material and plasma formation are sustained by way of some other kind of discharge (which may involve discharge, for instance arc discharge, whereby a current flows through the gasified product and/or plasma generated through surface discharge). Preferably, discharge is carried out in a non-steady manner (typically in pulses). In terms of, for instance, energy costs and acceleration efficiency during electromagnetic acceleration of the plasma, such a discharge is preferably carried out through flow of a large current over a short time.
Although not limited thereto, the above discharge can preferably be carried out, in the technology disclosed herein, in such a manner that the time of one discharge (1 shot) lasts for about 1 µsec to about 50 µsec (more preferably, from about 4 µsec to about 10 µsec). Preferably, the above discharge can be carried out in such a manner that the peak value of the discharge current is about 1 kA to about 30 kA (more preferably, about 5 kA to about 10 kA). The discharge intervals can be of, for instance, about 0.1 to about 10000 discharges (for instance, about 1 to about 100 discharges) per second. The discharge voltage can be of about 600 V to about 3000 V (preferably, about 800 V to about 1200 V). As regards discharge of charge stored in the capacitor, the capacitance of the capacitor can preferably be, for instance, of about 0.1 µF or more (typically of about 0.1 µF to about 1000 µF), ordinarily of about 1 µF or more (for instance about 1 µF to about 100 µF). Preferred ranges of charge amount for 1-shot discharge can be derived from the above-mentioned preferred capacitor capacitances and voltages.
Appropriate ranges of the energy released by 1-shot discharge may vary depending on the composition of the raw material (solid resin material) used, the type of carbonaceous film to be produced, the size of the raw material, the distance between electrodes and the arrangement of the substrate (for instance, distance from the raw material to the substrate, angle formed between the direction of the electromagnetic acceleration and the surface of the substrate). To produce a DLC film using PTFE as a raw material, for instance, the intended DLC film can be suitably produced by setting the energy per shot to about 0.1 J to about 10 J (preferably, about 0.5 J to about 5 J).

Ordinarily, the film production process disclosed herein can be preferably carried out in such a manner that at least the region extending from the location where the plasma is generated out of the solid resin material, as the raw material, up to the surface of the substrate is kept in a low pressure environment (in other words, in such a manner that the plasma is formed in a low pressure environment and the plasma is deposited on the substrate in a low pressure environment). For instance, at least the region extending from the front face (surface on the side of surface discharge) of the solid resin material, as the raw material, to the surface of the substrate may be kept in a low pressure environment. A suitable degree of low pressure may be, for instance, a pressure no greater than about 10⁻¹ Pa (typically, from about 10⁻¹ Pa to about 10⁻⁸ Pa), ordinarily a pressure no greater than about 10⁻² Pa (typically, from about 10⁻² Pa to about 10⁻⁵ Pa, for instance from about 10⁻² Pa to about 10⁻³ Pa). The film production apparatus disclosed herein can further comprise a reactor (for instance, a vacuum chamber) in which the above-mentioned low pressure environment can be realized. Preferably, the film production apparatus is constructed in such a manner that, for instance, at least the region extending from the front face of the raw material (surface discharge-side) to the surface of the substrate is arranged within that reactor. In a yet more preferred example, the electrodes, the raw material and the substrate are housed inside the above-mentioned reactor.
The film production process disclosed herein can be carried out also under pressure conditions other than the above-described low pressure environment. For instance, plasma generation and deposition on the substrate may be carried out in air at normal pressure (atmospheric pressure), or in any other atmosphere (for instance in an inert gas such as nitrogen gas).

Based on the technology disclosed herein, carbonaceous films of various thicknesses can be produced by adjusting, for instance, the film production conditions. Although not particularly limited thereto, the technology can be preferably used for producing a carbonaceous film (for instance, a DLC film) having a thickness of, for instance, about 1 nm to about 10 µm. The substrate on which the carbonaceous film is to be formed (this includes a "material to be treated" in a surface treatment that involves formation of the carbonaceous film) may be appropriately selected in accordance with the intended purpose. The material, shape and the like of the substrate are not particularly limited. The substrates used may be, for instance, the same substrates on which films are deposited by conventional plasma CVD and the like.

Configuration examples of a film production apparatus where the process disclosed herein can be used, as well as film production examples using the apparatus, are explained below with reference to accompanying drawings. However, the present invention is in no way meant to be limited to or by such specific examples.

### <Example 1: Apparatus configuration example>

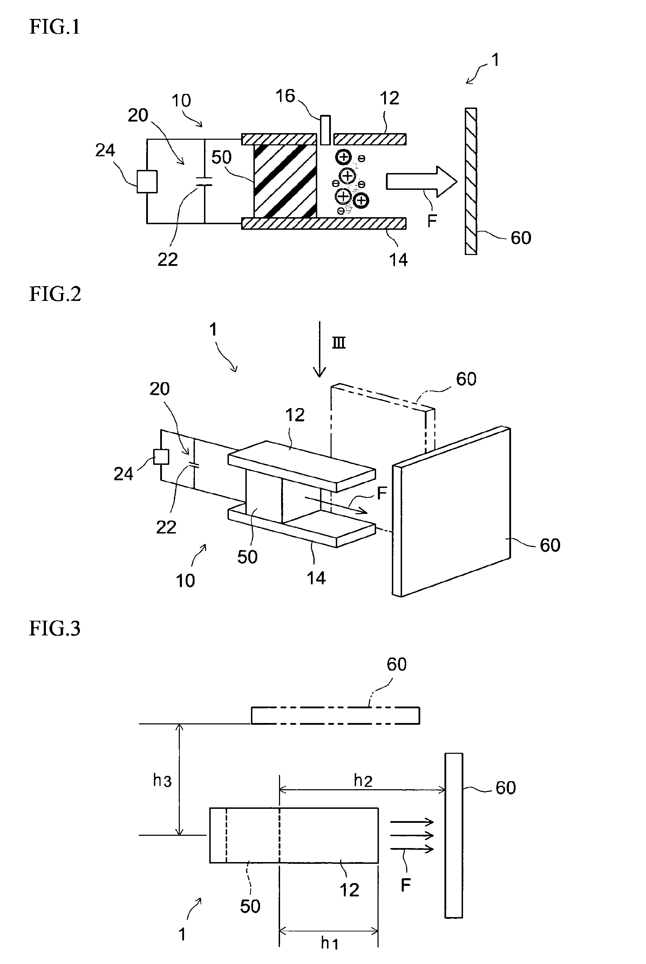

Figs. 1 to 3 illustrate a configuration example of the film production apparatus according to the present invention. Broadly, the film production apparatus 1 comprises a pair of plate-like electrodes (electrode plates) 12, 14, and a voltage applying means 20 for applying voltage across the electrodes. The foregoing elements constitute a discharge means 10 that applies discharge energy to a raw material 50 that is sandwiched between the electrodes 12, 14.
The electrodes 12, 14 are shaped as strip-like plates, comprise a conductive material such as copper (Cu), and are opposingly disposed substantially parallelly to each other with a predetermined gap in between. The raw material 50 comprising an insulating solid resin material (for instance PTFE) is sandwiched between the electrodes 12, 14. In the present embodiment, the electrodes 12, 14 function also as raw material holders. The raw material 50 is disposed towards one end side of the electrodes 12, 14 in the longitudinal direction thereof. The other end side of the electrodes 12, 14 extends protruding beyond the raw material 50. A substrate 60, on which a film is to be deposited, is disposed in front of the protruding electrodes, substantially perpendicular to the protruding direction (in other words, the longitudinal direction of the electrodes coincides substantially with the normal direction of the substrate 60).

The voltage applying means 20 comprises a capacitor 22 connected between the electrode 12 and the electrode 14, and a DC power source 24 electrically connected in parallel to the capacitor and functioning as a charging power supply of the capacitor. The DC power source 24 is connected in such a manner that the electrode 12 is the negative electrode (cathode) disposed at the top in Fig. 1, and the other electrode 14 is the positive electrode (anode) when the apparatus 1 is not in operation (in a non-discharge state). Although not shown in the figures, the electrode (cathode) 12 is connected to ground.
An igniter 16 is disposed in the vicinity of the front face of the raw material 50 (surface on the side at which the electrodes 12, 14 protrude, i.e. surface on the side of the substrate 60). The igniter 16 is connected to an igniter power source not shown (more specifically, the anode of the igniter power source is connected to the igniter 16, while the cathode of the igniter power source is connected to ground). The igniter 16 is configured in such a manner so as to be capable of performing small discharges between the electrodes 12, 14 at an arbitrary timing. The igniter is not shown in Fig. 2 and Fig. 3. The circuitry (capacitor, DC power source) is further omitted in Fig. 3.

The operation of the apparatus 1 illustrated in Figs. 1 to 3 will be explained next for an example in which the raw material 50 is PTFE.
(1) Small pulse discharge occurs at the leading end of the igniter 16 through application of pulsed high-voltage from the igniter power source to the igniter 16. This discharge (trigger discharge) causes part of the raw material 50 to sublimate, whereupon a small amount of plasma forms between the electrodes 12, 14 through plasma excitation.
(2) The plasma forms a high-conductivity region between the electrodes 12, 14. This high-conductivity region triggers a short-circuit (i.e. a dielectric breakdown) between the electrodes 12, 14 that causes the charge stored in the capacitor 22 connected to the electrodes to flow all at once, giving rise to a main discharge (typically, surface discharge along the surface of the raw material 50 and subsequent arc discharge).
(3) The current from the main discharge imparts energy, in the form of Joule heating and radiation, to the raw material 50, causing the latter to sublimate. Part of the sublimate is ionized into plasma that is accelerated electromagnetically in the rightward direction of Fig. 1 (downstream direction, direction of the arrow F) by electromagnetic forces created by the main discharge current and the self-induced magnetic field. The sublimate is also accelerated on account of gas dynamics effects derived from the expansion of a high-enthalpy gas.
(4) Such electrodynamic and gas-dynamic accelerations cause the plasma to accelerate in the downstream direction, to be discharged out of the electrodes 12, 14 while expanding in the discharge region. The plasma (plasma constituent component) becomes deposited on the surface of the substrate 60, to form a carbonaceous film (for instance, a DLC film). The carbonaceous film may comprise fluorine (F) derived from the raw material.

### <Example 2: Apparatus configuration example>

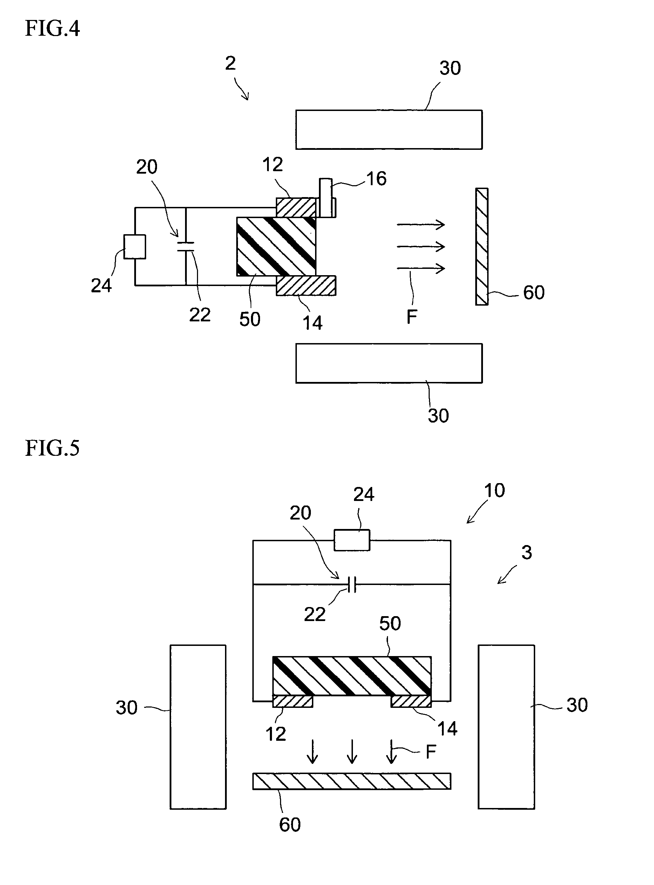

In the apparatus 1 in Example 1, the electrodes 12, 14 are provided protruding beyond the raw material 50 towards the substrate 60, such that the position (motion direction, motion speed, expansion and the like) of the plasma generated from the raw material 50 is controlled by means of this protruding portion. In such an embodiment, the position of the plasma is controlled (for instance by acceleration) utilizing mainly the self-induced magnetic field. This allows simplifying the configuration of the apparatus while affording good energy efficiency.
In another embodiment of the disclosed apparatus there can be provided, separately from the electrodes, a magnetic field generating means (i.e. an external magnetic field generating means) that controls the position of the generated plasma. Fig. 4 illustrates an example of a film production apparatus in such an embodiment. In the explanation that follows, elements of function identical to those in the apparatus 1 illustrated in Fig. 1 will be denoted with identical reference numerals, and a redundant explanation thereof will be omitted.

The electrodes 12, 14 provided in the film production apparatus 2 illustrated in Fig. 4 are shorter than those illustrated in Fig. 1. The electrodes 12, 14 flank the front face side (substrate 60 side) of the raw material 50 and protrude somewhat from the raw material 50 towards the substrate 60. A magnetic field generating means 30 is provided surrounding the path that extends from the front face of the raw material 50 up to the substrate 60. The magnetic field generating means 30 may be, for instance, a permanent magnet, a coil or the like, so long as it is configured so as to control the position (motion direction, motion speed, expansion and the like) of the generated plasma. In the example illustrated in Fig. 4, the magnetic field generating means 30 is provided at a position encompassing the entire length of the path that extends from the front face of the raw material 50 up to the substrate 60. However, the area over which the magnetic field generating means 30 is provided is not particularly limited thereto, so long as it can influence the generated plasma. For instance, the magnetic field generating means 30 may be provided just over part of the length of the above-mentioned path. The magnetic field generating means 30 may also be disposed around the path, like a ring, or may be disposed at some locations around the path (for instance at four sites, above, below, left and right).

In the apparatus 2 illustrated in Fig. 4, plasma generated from the raw material 50 can be accelerated or decelerated towards the substrate 60 by way of the magnetic field generated by the magnetic field generating means 30, through the interaction between the magnetic field and the main discharge current (with an apparatus configuration wherein a permanent magnet is used as the magnetic field generating means 30, such that the permanent magnet generates a magnetic field (magnetic field perpendicular to the paper in Fig. 4) that is perpendicular to the straight line that joins the electrodes 12, 16 (perpendicular to the electric force lines between the electrodes)). Such an embodiment allows regulating, for instance, the timing, intensity and direction of the magnetic field generated by the magnetic field generating means 30, whereby the plasma position can be controlled more accurately. A carbonaceous film (for instance, a DLC film) of higher quality can be obtained as a result. The apparatus may also be configured to generate a magnetic field perpendicular to the paper in Fig. 4 by using a plurality of coils as the magnetic field generating means 30, with current flowing through each of these coils in the left-right direction of Fig. 4. Alternatively, the apparatus may be configured by using, as the magnetic field generating means 30, a coil that surrounds, ring-like, the path from the front face of the raw material 50 up to the substrate 60, in such a manner that the expansion of the plasma is restricted (confined) by the magnetic field generated through flow of current in the coil.

### <Example 3: Apparatus configuration example>

In the apparatuses according to Examples 1 and 2, the raw material 50 was sandwiched between two electrodes 12, 14 disposed parallel to each other. However, the arrangement of the electrodes 12, 14 is not limited thereto. For instance, the electrode 12 and the electrode 14 may be provided, with a gap in between, on the front face (surface on the side of the substrate 60) of the raw material 50 that is held by a raw material holder not shown, as in the film production apparatus 3 illustrated in Fig. 5. Plasma can be generated herein by using an ingiter, not shown, to elicit a small discharge in the vicinity of the surface of the raw material 50 exposed between the electrodes 12, 14, and form thereby a main discharge between the electrodes 12, 14. A magnetic field generating means 30 may be further provided, as illustrated in Fig. 5, around the path that extends from the electrodes 12, 14 up to the substrate 60, such that the position of the plasma can be controlled by way of the magnetic field generated by the magnetic field generating means 30. As explained in Example 2, there are various configurations that allow applying a magnetic field for accelerating or decelerating the plasma towards the substrate 60, and that allow applying a magnetic field for restricting expansion of the plasma. A configuration can be preferably used herein that allows applying a magnetic field in a direction (direction perpendicular to the paper) that is perpendicular to electric force lines between the electrodes 12, 14 (mainly the left-right direction in Fig. 5), by using a permanent magnet or a coil (more preferably a permanent magnet) as the magnetic field generating means and by causing current to flow in approximately the same direction as that of the above-described path.

### <Example 4: Apparatus configuration example>

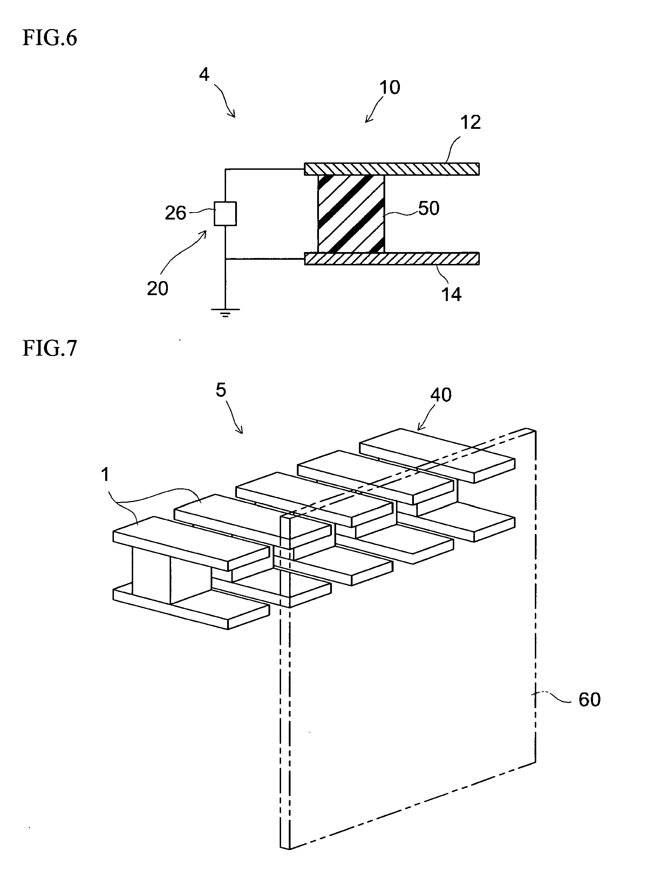

The film production apparatus 4 illustrated in Fig. 6 is a modification of the apparatus according to Example 1, but now a high-frequency power source 26 is used as the voltage applying means. In the apparatus 4, the high-frequency power source 26 is connected to the electrodes 12, 14. As the high-frequency power source 26 there can be used an ordinary high-frequency device (typically equipped with a matching circuit) configured so as to be capable of applying a high-frequency, for instance 10 to 1000 W at a frequency of 13.56 MHz. The timing of the main discharge (discharge frequency and discharge length) can be controlled based on the operation conditions of the high-frequency power source 26. The main discharge may also be controlled using an igniter, as in Fig. 1.
The film production apparatus disclosed here can be configured in the same way as ordinary plasma CVD equipment, in such a manner so as to be capable of applying a bias voltage (typically negative bias voltage) to the substrate 60 or to a substrate holder (not shown) disposed on the rear surface of the substrate 60. For instance, the apparatus 4 illustrated in Fig. 6 applies a self-bias voltage to the substrate 60, or to a substrate holder (not shown) disposed on the rear surface of the substrate 60, through operation of the high-frequency power source 26. Alternatively, bias voltage may be applied by way of a circuit separate from the high-frequency power source 26. In such a configuration, the plasma generated from the raw material 50 can be accelerated electrostatically towards the substrate 60 by means of the above-mentioned bias voltage (typically, by sheath voltage on the substrate front face). A carbonaceous film (for instance, a DLC film) of higher quality can be obtained as a result.

### <Example 5: Apparatus configuration example>

The number of electrodes in the film production apparatus according to the present invention is not limited to a pair, as in the apparatuses 1 to 4 according to Examples 1 to 4, and there may be provided two or more pairs of electrodes for imparting discharge energy to the raw material and generating thereby a plasma from the raw material. For instance, a film production apparatus 5 illustrated in Fig. 7 may have plasma generating unit array 40 that comprises an array of a plurality of the film production apparatuses 1 illustrated in Fig. 1 (which can be regarded as plasma generating units). The film production apparatus 5 comprising such an array 40 allows supplying plasma (depositing a film) efficiently over a wider area, which in turn allows increasing the production efficiency of the carbonaceous film. Such an apparatus configuration is also suitable for producing films having a large surface area.

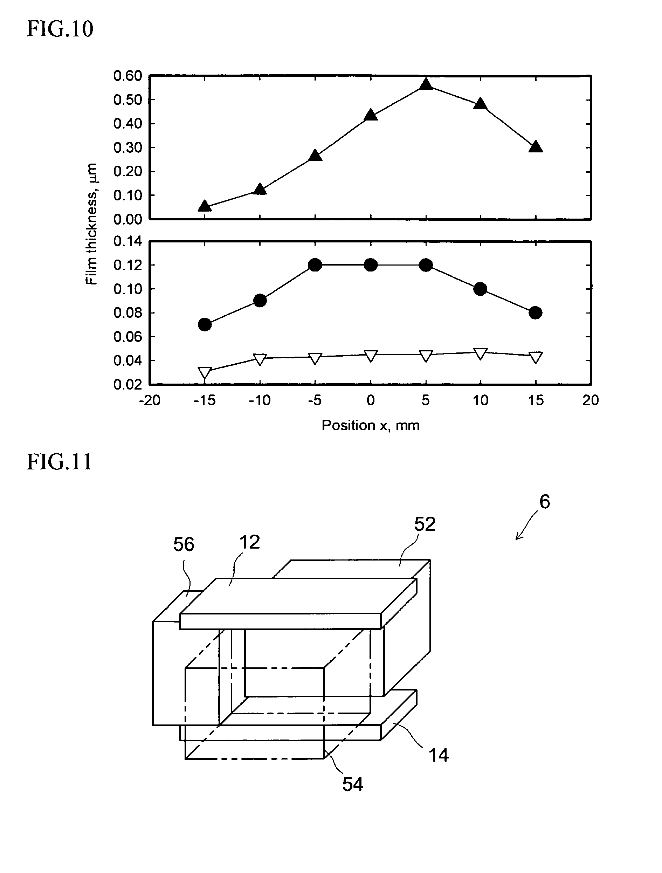

The film production apparatus according to the present invention may also be used configured in a configuration where plural materials (a plurality of blocks) are disposed relative to one pair of electrodes. The compositions of the raw materials may be identical or mutually dissimilar. The apparatus may be configured, for instance, as the film production apparatus 6 illustrated in Fig. 11, with raw materials 52, 54 sandwiched between the ends of short strip-like electrodes 12, 14 in the width direction thereof. A stopper 56 that prevents dissipation of plasma rearwards from a gap between the raw material 52 and the raw material 54 is preferably provided at the rear end portion of the electrodes 12, 14 (on the left in Fig. 11). An insulating ceramic block or the like can be preferably used as the stopper 56. In such a configuration, discharge between the electrodes 12, 14 elicits gasification and plasma excitation of the raw materials 52, 54, mainly at the opposing surfaces thereof. The plasma can thus be accelerated on account of electromagnetic and gas dynamics forces, to be discharged in the outlet direction of the electrodes 12, 14 (rightwards in Fig. 11). Fig. 11 does not depict the voltage applying means (which may comprise, for instance, the capacitor 22 and the DC power source 24, as in the apparatus 1 illustrated in Fig. 1, or the high-frequency power source 26, as in the apparatus 4 illustrated in Fig. 6) or the igniter that is provided as the case may require. The stopper 56 may comprise a solid resin material having a composition identical to or different from that of the raw materials 52, 54. The stopper 56 can then be used also as a raw material (plasma source).

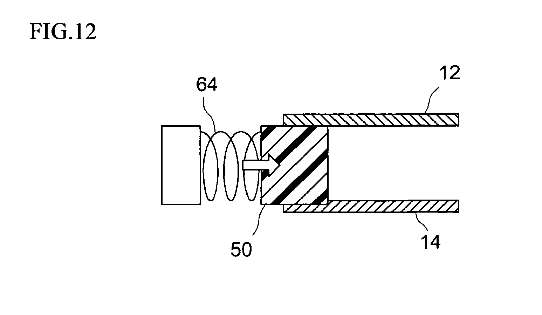

The surface of the solid organic material employed as a raw material is consumed gradually as the material is used. As a result, the position of the surface of the raw material (surface on the side of surface discharge) retreats gradually as there increases the cumulative amount of plasma that forms out of the raw material. To prevent such variation in the position of the surface, the film production apparatus disclosed herein may comprise a raw material supply means that supplies raw material in such a way so as to maintain an appropriate surface position. The raw material supply means may comprise an urging means 64 that urges the raw material 50 towards the front side (the side where the raw material is gasified, typically the surface discharge side), for instance as illustrated in Fig. 12. The urging means 64 may use an ordinary elastic member such as a coil spring, a flat spring or the like. To achieve the above-mentioned appropriate surface position, a locking portion for preventing displacement of the raw material 50 can be provided, against the urging force of the urging means 64, at part of a raw material holder that holds the raw material 50 (in the example illustrated in Fig. 12, the electrodes 12, 14 function as the raw material holder). In the example illustrated in Fig. 12, a shoulder provided on the inner face of the electrode 14 (face in contact with the raw material 50) functions as the locking portion. In such a configuration, the raw material 50 is fed forwards (rightwards in Fig. 12) in proportion to the amount thereof that is consumed, to allow thereby the surface of the raw material 50 (surface discharge side, i.e. surface that is consumed) to be maintained at an appropriate position.

### <Example 6: film production example>

A carbonaceous film was produced using the film production apparatus 1 having the construction illustrated in Figs. 1 to 3. The raw material 50 used was PTFE shaped as a quadrangular prism having a 10 mm × 10 mm square bottom and a height of 20 mm. The raw material was prepared by cutting a commercially available PTFE resin to the above shape. The electrodes 12, 14 used were copper strips 10 mm wide, 40 mm long and 2 mm thick. The electrodes 12, 14 were disposed substantially parallel to each other, with a gap of 20 mm in between where the raw material 50 was sandwiched. As illustrated in Fig. 3, the distance (effective electrode length, denoted in Fig. 3 as h1) from the surface (front face) of the raw material 50 up to the leading end of the electrodes 12, 14 was 24 mm. As illustrated in Fig. 1, a through-hole is provided in the electrode 12 disposed at the upper end of the raw material 50, in the vicinity of the surface (front face) of the raw material. The igniter 16 is disposed in the through-hole. To the electrodes 12, 14 there is connected a capacitor 22 having a capacitance of 3 µF, and the DC power source 24, in parallel with the capacitor.

The apparatus 1 having such a configuration was placed in a vacuum chamber (not shown) together with the substrate 60 on which a film is to be formed. The pressure in the chamber is adjusted to about 10⁻³ Pa. The substrate 60 used was a stainless steel plate 40 mm long, 40 mm wide and 2 mm thick, that was disposed at a position at which the distance from the front face of the raw material 50 to the surface of the substrate (distance h2 illustrated in Fig. 3) is 40 mm, and in such a manner that the longitudinal direction of the electrodes 12, 14 coincided substantially with the normal direction of the substrate 60.

Carbonaceous films were formed on the surface of various substrates by setting the discharge intervals (shot intervals) from the capacitor 22 to 4 Hz, and by carrying out discharge over a set number of times (for instance, 100 × 10³ shots for an energy per shot of 1 J) using four energies, 1 J, 3 J, 5 J and 7 J, released per discharge (energy per shot), to a total energy of 100 kJ. The energy per shot (corresponding to the charge energy stored in the capacitor 22 and calculated on the basis of the formula E=1/2CV², using the capacitance C and the charge voltage V of the capacitor 22) was adjusted to the above-mentioned values by modifying the voltage (V) that was applied by the DC power source 24. The discharge intervals (discharge timing) were controlled based on the timing of the small discharges by the igniter 26. That is, discharge by the igniter 26 took place at 0.25 second intervals to elicit the subsequent main discharge (discharge of charge stored in the capacitor 22) at 4 Hz intervals.

Raman spectra of the films deposited in the substrates were measured thereafter at five positions of each substrate, namely, at the center (at a position 20 mm from the upper edge and 20 mm from the left edge), top (at a position 15 mm above the center, i.e. 5 mm from the upper edge and 20 mm from the left edge), bottom (at a position 15 mm below the center), right (at a position 15 mm to the right of the center), and left (at a position 15 mm to the left of the center).

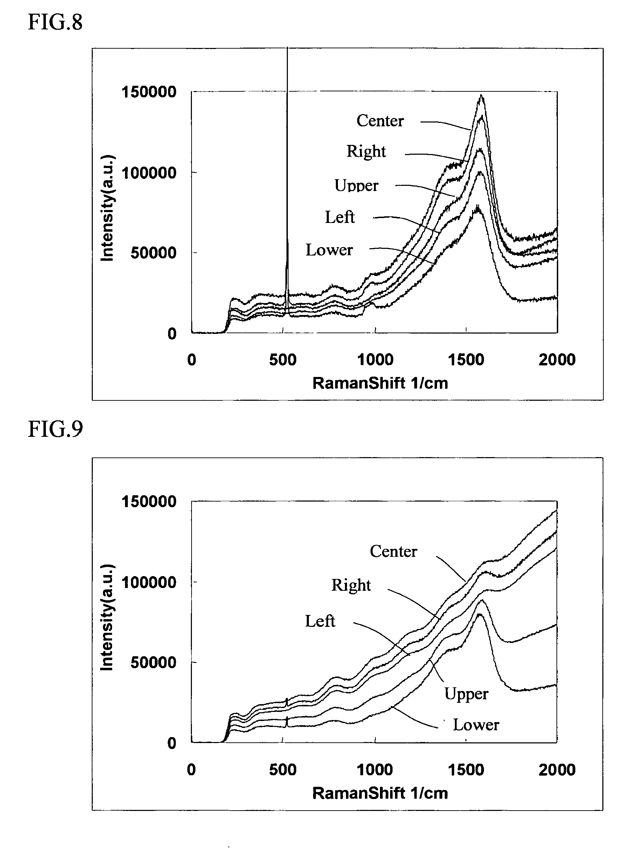

Fig. 8 illustrates Raman spectra of films produced under conditions of 1 J of energy per shot (hereafter, "1 J/shot"). To facilitate viewing of the spectra and avoid overlapping of the latter, the Raman spectra measured at the respective locations have been depicted staggered from the top down, in the order of the spectra for the center, right, top, left and bottom.
As illustrated in Fig. 8, Raman spectra characteristic of DLC were observed at each measurement site, i.e. spectra having a broad peak in the vicinity of 1350 cm⁻¹ (D band) overlapping with a broad peak in the vicinity of 1550 cm⁻¹ (G band).
The spectra were divided into a D band peak (D-peak) and a G band peak (G-peak), to calculate the ratio (ID/IG ratio) between the D peak intensity (ID) and the G peak intensity (IG). Upon comparison, a good match was observed vis-à-vis the ID/IG ratio of commercially available DLC films obtained by conventional plasma CVD (using a raw material gas). The position of the G-peak (G position) matched well that of the commercially available DLC film.

The proportion of SP³ bonds comprised in the films produced under the above-mentioned conditions of 1 J/shot were estimated at about 10% based on the ID/IG ratio and position of the G-peak obtained from the above spectra. The estimation was carried out in accordance with the amorphization trajectory method proposed by Ferrari et al. (Ref.: Phys. Rev. B 61, 14095-14107 (2000), Interpretation of Raman spectra of disordered and amorphous carbon, A. C. Ferrari and J. Robertson).

The hardness of the film formed at the center of the substrate under the above-mentioned conditions of 1 J/shot was of 13.85 GPa, as measured by nanoindentation. This hardness is comparable to the hardness of commercially available DLC films obtained by plasma CVD (using a raw material gas). The results indicated that the film produced in the present example was a DLC film. Results from Auger electron spectroscopy revealed that the DLC film obtained under the above-described conditions comprised carbon (C) and also fluorine (F) (i.e., the film was a DLC film comprising fluorine).

Fig. 9 illustrates Raman spectra of a carbonaceous film produced under conditions of 3 J/shot. To facilitate viewing of the spectra and avoid overlapping of the latter, the Raman spectra measured at the respective locations have been depicted staggered from the top down, in the order of the spectra for the center, right, top, left and bottom. As Fig. 9 shows, the spectra observed under these conditions, at the top and bottom of the substrate 60, were also characteristic of a DLC film, while spectra observed at the center, right and left, however, were not characteristic of the DLC film.
No spectrum characteristic of DLC films was observed at any of the five sites in carbonaceous films produced under conditions of 5 J/shot and 7 J/shot. Among the above, the carbonaceous film produced under conditions of 7 J/shot exhibited a Raman spectrum characteristic of graphite at the center of the substrate 60.
The results in the present example show that the type (structure) of the obtained film can be adjusted based on the energy per shot. When producing for instance a DLC film, better results are obtained by setting a comparatively low energy per shot, in the apparatus and the production conditions used it the present example.

### <Example 7: film production example>

In Example 6, the position at which the substrate 60 is disposed was changed from ahead of the electrodes (front arrangement) to the side of the electrodes (lateral arrangement). In the present example, specifically, the substrate 60 lateral to the electrodes 12, 14 was disposed in such a manner that the distance from the center of the electrodes in the width direction thereof to the surface of the substrate was 25 mm (distance h3 illustrated in Fig. 3). Unlike in Example 6, the substrate 60 in this lateral arrangement is disposed laterally removed from the direction along which the plasma is accelerated, with the substrate 60 standing substantially parallel to the acceleration direction. Except for the arrangement of the substrate 60, a carbonaceous film was produced in the same way as in Example 6 under four conditions which included 1 J/shot, 3 J/shot, 5 J/shot and 7 J/shot. In the present example, specifically, a carbonaceous film was produced on the substrate 60 that was arranged laterally to the direction in which the plasma is accelerated (in other words, the substrate was disposed in such a manner that the gas containing the plasma generated from the raw material 50 struck the substrate 60 without undergoing any deliberate acceleration (non-accelerated gas)). Observation of the Raman spectra of the obtained carbonaceous film revealed spectra characteristic of DLC films, under all conditions, as was the case in Example 6.
The results according to Examples 6 and 7 indicate that, with the apparatus configuration and under the producing conditions employed in the examples, causing plasma generated from the raw material (PTFE) to be accelerated by electromagnetic forces towards the substrate (in other words, disposing the substrate within an area onto which plasma is irradiated), is highly effective for forming a DLC film.

### <Example 8: film production example>

In Example 6 there were used three distances (h2) of 40 mm, 80 mm and 120 mm from the front face of the raw material 50 to the surface of the substrate 60. A carbonaceous film was formed in the same way as in Example 6, but herein the energy per shot was fixed at 1 J. Raman spectrum of the obtained film were measured in the same way as in Example 6. It was found that Raman spectra differences tended to become smaller, for each measurement point (5 sites), as the distance h2 increased. These results indicate that concentration differences in the plasma generated from the raw material 50 (for instance, bias relative to the frontal direction of the substrate 60) can be mitigated by lengthening the distance to the substrate surface (h2), so that a more uniform film can be formed over a wider area of the substrate 60.

The thickness of the film formed at various portions of the substrate in the left-right direction was measured, for each distance (h2), by level-difference measurement at the central portion in the height direction of the substrate (i.e. at a position 20 mm from the upper edge).
More specifically, a carbonaceous film was produced (formed) with a mask tape affixed beforehand to the central portions of the sites at which the film thickness was to be measured. The mask tape was stripped off once the film was formed, to reveal level differences between the sites where the carbonaceous film was formed and the sites where the film was not formed (sites where the substrate surface was exposed). The level-difference height was measured using a stylus profilometer. The results are illustrated in Fig. 10. The plot of black triangles illustrates the measurement results on a film produced with h2 set to 40 mm, the plot of black circles illustrates the results with h2 set to 80 mm, and the plot of white triangles illustrates the results with h2 set to 120 mm. The X-axis of the graph represents displacement to the right (+ direction) or the left (-direction) from the center (0 mm) of the substrate. The Y-axis represents film thickness.
The figure shows that film thickness differences in the left-right direction of the substrate decrease as h2 lengthens. When h2 was 120 mm, specifically, the uniformity achieved involved a difference of no more than 20% (more specifically, no more than 10%) between the position exhibiting the largest film thickness (herein, the position at +10 mm) and positions within 20 mm to the left and right. This finding supports the above-described result to the effect that increasing h2 allows a more uniform film to be formed over a wider area. The spatial distribution of the Raman spectra became likewise more uniform when h2 was larger.

## Claims

1. A process for forming a carbonaceous film on a substrate, the process comprising:
preparing a solid organic material as a raw material;
forming a plasma from the material by applying discharge energy to said material; and
forming a carbonaceous film by depositing the plasma on a substrate.

2. The process according to claim 1, wherein said discharge energy is applied in pulses.

3. The process according to claim 1 or 2, further comprising: accelerating said formed plasma towards said substrate by way of electromagnetic forces.

4. The process according to claim 3, wherein said substrate is disposed within a range of 60° relative to the acceleration direction of said plasma.

5. The process according to any of claims 1 to 4, wherein said carbonaceous film is a diamond-like carbon film.

6. The process according to claim 1 or 2, wherein said material forms a gasified product of which at least part is excited into plasma through application of said discharge energy, and a carbonaceous film is formed through deposition of said gasified product, which is non-accelerated, onto the substrate.

7. The process according to any of claims 1 to 6, wherein a main component of said solid organic material is a solid resin containing fluorine.

8. An apparatus for forming a carbonaceous film on a substrate, comprising:
a raw material holder that holds a solid organic material as a raw material; and
discharge means configured such that a plasma can be formed from said material by imparting discharge energy to said material, and including a pair of electrodes and voltage applying means for applying voltage across the electrodes.

9. The apparatus according to claim 8, comprising electromagnetic acceleration means for accelerating said formed plasma, by way of electromagnetic forces, in a direction of separation from said material.

10. The apparatus according to claim 9, wherein said acceleration means is configured such that said plasma can be accelerated in a direction within 60° relative to a position at which said substrate is disposed.

11. The apparatus according to claim 9 or 10,
wherein at least part of said pair of electrodes is provided in a shape such that the electrodes face each other protruding beyond said material towards where said substrate is disposed,
and wherein said electromagnetic acceleration means is formed so as to be capable of accelerating said plasma between said protruding electrodes by way of a current resulting from discharge and a self-induced magnetic field generated by the current.

12. The apparatus according to any of claims 9 to 11,
wherein said acceleration means includes a magnetic field generating means formed by a permanent magnet and configured so as to accelerate and decelerate said formed plasma.

13. The apparatus according to any of claims 8 to 12,
wherein said voltage applying means includes a capacitor electrically connected between said pair of electrodes; and
said discharge means is configured such that a plasma is formed from said material through discharge of charge stored in the capacitor.

14. The apparatus according to claim 13, wherein said discharge means further comprises an igniter that induces discharge of charge stored in said capacitor.

15. A diamond-like carbon film, produced using the process according to any one of claims 1 to 7 and having a substantially uniform film thickness.
